(19) Europäisches Patentamt
European Patent Office
Office européen des brevets

(11) **EP 2 733 846 B1**

(12) **EUROPEAN PATENT SPECIFICATION**

(45) Date of publication and mention
of the grant of the patent:
**07.01.2015 Bulletin 2015/02**

(51) Int Cl.:
***H03F 3/217*** *(2006.01)*

(21) Application number: **12290403.0**

(22) Date of filing: **20.11.2012**

(54) **Envelope modulator and method of operating an envelope modulator**

Hüllkurvenmodulator und Verfahren für den Betrieb eines Hüllkurvenmodulators

Modulateur d'enveloppe et procédé de fonctionnement d'un modulateur d'enveloppe

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**21.05.2014 Bulletin 2014/21**

(73) Proprietor: **ALCATEL LUCENT
92100 Boulogne-Billancourt (FR)**

(72) Inventors:
• **Haslach, Christoph, Dr.
70178 Stuttgart (DE)**
• **Markert, Daniel
70435 Stuttgart (DE)**
• **Fischer, Georg, Prof. Dr.-Ing.
90425 Nürnberg (DE)**

(74) Representative: **Wetzel, Emmanuelle
Alcatel-Lucent Deutschland AG
Intellectual Property & Standards
Lorenzstrasse 10
70430 Stuttgart-Zuffenhausen (DE)**

(56) References cited:
**EP-A2- 1 271 870      WO-A1-2009/072071
WO-A2-2007/069191**

## Description

### Field of the invention

The present invention relates to an envelope modulator, particularly for a polar transmitter, and to a method of operating an envelope modulator.

The present invention further relates to a polar transmitter comprising an envelope modulator.

### Background

Envelope modulators are per se known and e.g. used in polar transmitters for communications applications, especially wireless systems, to modulate an amplitude of carrier frequency signals. In many applications, the carrier frequency signals are in the RF range, for example several hundreds of MHz (Megahertz) to some GHz (Gigahertz). Envelope modulators may e.g. be used to control switching amplifiers (e.g. class-D) to provide energy efficient modulation for switch mode amplification.

It is an object of the present invention to provide an improved envelope modulator and an improved method of operating an envelope modulator that provide increased flexibility, particularly increased coding efficiency and linearity, in combination with advantageous pulse statistics, as compared to prior art systems.

WO 2009/072071 A1 discloses a transmitter comprising a pulse width pulse position modulator and method thereof. EP 1, 271,870 A2 discloses a switching mode power amplifier using PWM and PPM for band pass signals.

### Summary

According to the present invention, this object is achieved by an envelope modulator as defined by claim 1.

By considering both the amplitude signal and a feedback signal for determining the pulse width of output pulses, a more precise modulation and an increased linearity may be attained. Moreover, taking into consideration the feedback signal, processing errors and other disturbances (either deterministic or random) that affect signal processing in the envelope modulator or components thereof, may be compensated. A further advantage is that a number of pulses per carrier period may be reduced compared to conventional systems.

In contrast to conventional systems based on delta-sigma modulation, which provide output pulses with fixed pulse width, the envelope modulator according to the embodiments can provide output pulses of varying pulse width, which advantageously enables to increase linearity, especially for comparatively long lasting phases of an input signal with small amplitude.

Moreover, in contrast to conventional systems based on pulse-width modulation, the envelope modulator according to the embodiments can take into consideration a feedback signal and thus dynamically mitigate processing errors (which e.g. result from limited precision within digital signal processing components, processing bandwidth limitations, and the like) and disturbances thus also contributing to increased linearity and coding efficiency.

In other words, the envelope modulator according to the embodiments may determine a pulse width of output pulses depending on both the input signal to the envelope modulator, or its amplitude, respectively, and on the feedback signal that may e.g. carry information on processing errors, or deterministic errors if pulses are suppressed, within the envelope modulator and may thus contribute to compensate such errors by correspondingly adapting the pulse width of subsequent output pulses.

Thus, for subsequent clock cycles of the phase-modulated carrier signal, output pulses of varying pulse width may be provided by the envelope modulator.

According to an embodiment, said envelope modulator is configured to generate output pulses with two or more different pulse widths. It is particularly preferred if the envelope modulator is configured to generate a large number of different pulse widths, whereby linearity and coding efficiency is advantageously increased.

According to another embodiment, the envelope modulator may be configured to provide only a comparatively small number of different output pulse widths, which simplifies the generation of said output pulses. For example, according to an embodiment, the envelope modulator may be configured to provide four different pulse widths only.

According to another embodiment, said pulse is approximately a rectangular pulse, the rectangular form being quite simple so that pulse generation can be effected very efficiently. According to another embodiment, the output pulses are symmetric along a time coordinate.

Other embodiments are also possible, where one or more of the following features characterize the output pulses: non-rectangular pulse shape, binary amplitude levels (low and high), n-ary amplitude levels (n > 2, i.e. more than two amplitude levels for the output pulses. I.e., according to a further embodiment, output pulses could also have three different amplitude levels: -1, 0, +1 or 0, 0.5, 1.0, or the like.

According to a further embodiment, the envelope modulator is configured to generate said output pulses such that said output pulses are centered around a quarter of a duration of a clock cycle of said carrier signal. Thereby, a phase error may be avoided for varying pulse widths, because the center of the output pulse is "locked" with respect to the phase-modulated carrier signal, regardless of the pulse width. Of course, other reference "positions" for the output pulses to be centered around with respect to a clock cycle of said carrier signal may also be used, e.g. three quarters of the duration of a clock cycle or any other value.

According to a further embodiment, the envelope modulator is configured to, preferably at least approximately, determine the pulse width of the output pulses depending on the following equation:

$$PW = c1 * arcsin(y'(t)),$$

wherein PW represents said pulse width, wherein c1 represents a first constant, wherein arcsin() represents the inverse sine function, and wherein y'(t) represents a signal derived from a difference between said amplitude signal and said feedback signal. According to an embodiment, y'(t) may be scaled such that y'(t) is normally in the range of 0..1. If y'(t)<0, the pulse width PW may be set to 0, if y'(t)>1 the pulse width PW may be set to c1. For example, in one embodiment, the first constant c1 may be chosen according to:

$$c1 = Tc/Pi,$$

wherein Tc represents the cycle time of the carrier signal, i.e. Tc = 1 / fc (fc is the frequency of the carrier signal), and Pi ($\pi$) = 3.141...

In case that the pulses have ideal rectangular shape, the aforementioned arcsin-mapping generates a pulse width signal with a minimum of out of band and in-band distortion. This means there is a linear mapping between input amplitude A and the amplitude of the signals that is generated by filtering the output signal with a bandpass filter at the carrier frequency.

Advantageously, the envelope modulator is configured to compare said determined pulse width of said output pulse with a predetermined threshold value, and to not output said output pulse if said determined pulse width is smaller than said predetermined threshold value. I.e., the envelope modulator is not required to generate an output pulse for each clock cycle. Especially for very small values of the amplitude signal, where rather small pulse widths would be required for the output pulses, the desired small pulse widths might be difficult or impossible to obtain within a real implementation with sufficient precision. This is e.g. due to nonvanishing switching times of switching transistors that may be used in a switch mode (e.g., class-D) amplifier that is controlled with the output signal of the envelope modulator according to the embodiments. In these cases, according to the present embodiment, no output pulse is generated. A potential error that may result from not outputting any pulse instead of a rather short output pulse may advantageously be compensated by the feedback mechanism according to the embodiments. This embodiment enables error-free or nearly error-free output pulse generation for larger values of the amplitude signal, and for the smaller values of the amplitude signal, the feedback mechanism ensures compensation of errors introduced by omitting output pulses. Alternatively, in contrast to checking the pulse width for exceeding the threshold value, a further threshold may be defined for a certain value y' of an amplitude. If y' is smaller than this threshold, no pulse will be generated.

For example, the predetermined threshold value for the minimum pulse width to be generated may be chosen depending on the technology (CMOS, ..) and implementation details of the envelope modulator. Preferably, the predetermined threshold value is chosen such that pulse widths that correspond with the predetermined threshold value may be generated with sufficient precision. If the envelope modulator determines that pulse widths smaller than the predetermined threshold value are required, i.e. because of small amplitude signal values, the envelope modulator does not output any output pulse in the corresponding clock cycle of the phase-modulated carrier signal. In this case, a suboptimal approximation of the amplitude signal is tolerated, and the corresponding error may be compensated by the feedback signal, that is also considered for pulse width determination according to the embodiments.

According to a further embodiment, the envelope modulator comprises a sampling unit that is configured to receive said phase-modulated carrier signal and to capture, synchronously with said phase-modulated carrier signal

a) a sample of said amplitude signal, or

b) a sample of a signal derived from said amplitude signal, or

c) a sample of a signal derived from said amplitude signal and a previously sampled version of said amplitude signal.

3

The sampling unit may e.g. be implemented in the form of a sample and hold circuit, which is well known by the skilled man. By using the sampling unit which is synchronized with the phase-modulated carrier signal, it is ensured that samples of the amplitude signal or of a signal derived from said amplitude signal may be obtained which have a well-known phase relation / delay with respect to the phase-modulated carrier signal. This, in turn, enables to provide the output pulses provided by the envelope modulator in a synchronized fashion with respect to the phase-modulated carrier signal.

According to a further embodiment, the envelope modulator comprises a feedback loop for providing said feedback signal and a combiner, preferably an adder, which combines (i.e. adds/subtracts) said amplitude signal and said feedback signal to obtain an error signal. Thus, errors in the processing chain may be compensated. Especially when providing a threshold value for the minimum pulse width, errors introduced by omitting "too short" output pulses, may be compensated, too, by the feedback loop according to the present embodiment. Integrator means or a low-pass filter may also be used according to an embodiment, in order to accumulate the feedback signal or the error signal, respectively.

According to a further embodiment, the envelope modulator comprises pulse generating means that are configured to generate one or more output pulses. The pulse width of the output pulses comprises information on the amplitude signal and may e.g. be used to drive a switched mode amplifier.

A further solution to the object of the present invention is provided by a polar transmitter comprising an envelope modulator according to the embodiments, wherein said polar transmitter further comprises means for obtaining an amplitude signal and a phase signal depending on an input signal, means for phase modulating a carrier signal depending on said phase signal to obtain a phase-modulated carrier signal, and wherein said polar transmitter is configured to provide said amplitude signal and said phase-modulated carrier signal to said envelope modulator.

A further solution to the object of the present invention is provided by a method of operating an envelope modulator, particularly for a polar transmitter, wherein said envelope modulator is configured to receive an amplitude signal and a phase-modulated carrier signal, wherein said envelope modulator outputs for at least one clock cycle of said phase-modulated carrier signal an output pulse, wherein a pulse width of said output pulse is determined depending on said amplitude signal and on a feedback signal derived from said amplitude signal.

Further advantageous embodiments are given by the dependent claims.

**Brief description of the figures**

Further features, aspects and advantages of the present invention are given in the following detailed description with reference to the drawings in which:

| | |
|---|---|
| Figure 1 | depicts a schematic block diagram of an envelope modulator according to an embodiment, |
| Figure 2a | schematically depicts one clock cycle of a carrier signal that can be used for the envelope modulator according to the embodiments, |
| Figure 2b, 2c | schematically depict output pulses that can be generated using the envelope modulator according to the embodiments, |
| Figure 3a, 3b | schematically depict a block diagram of a polar transmitter according to an embodiment, |
| Figure 4a, 4b, 4c | depict a schematic block diagram of an envelope modulator according to further embodiments, |
| Figure 5a, 5b | depict a simplified flow chart of a method according to an embodiment, |
| Figure 6 | depicts a schematic block diagram of an envelope modulator according to a further embodiment, |
| Figure 7 | depicts a cumulative density function of the probabilities for different pulse widths according to an embodiment, and |
| Figure 8 | depicts a schematic block diagram of pulse generator means according to an embodiment. |

**Description of the embodiments**

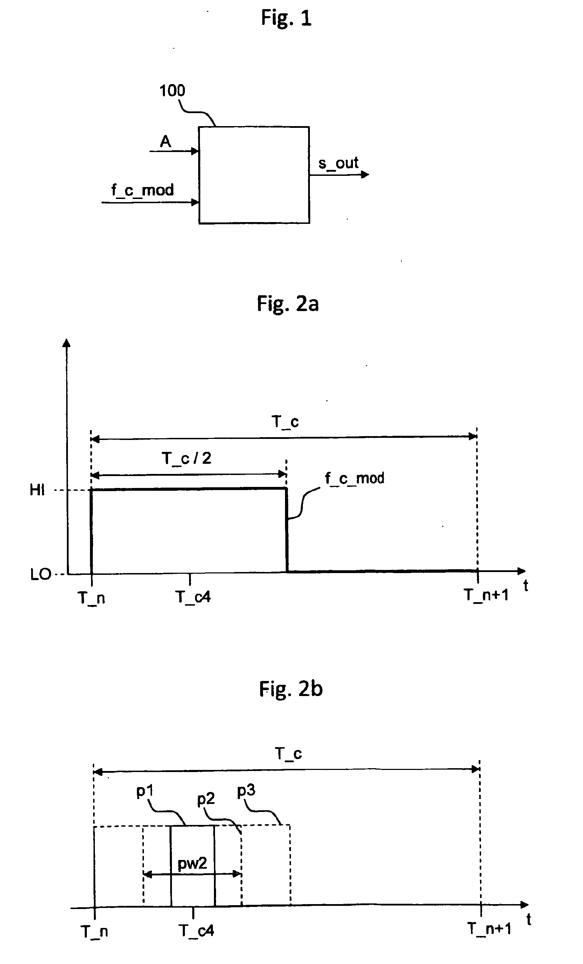

Figure 1 depicts a schematic block diagram of an envelope modulator 100 according to an embodiment. The envelope modulator 100 is configured to receive an amplitude signal A and a phase-modulated carrier signal f_c_mod at respective inputs, and to output for at least one clock cycle of said phase-modulated carrier signal f_c_mod an output pulse, wherein a pulse width of said output pulse is determined depending on said amplitude signal A and on a feedback signal derived from said amplitude signal A.

Thus, basically, the envelope modulator 100 transforms the amplitude signal A to a corresponding sequence of output pulses s_out, wherein the pulse width of the output pulses depends inter alia on the values of the amplitude signal A.

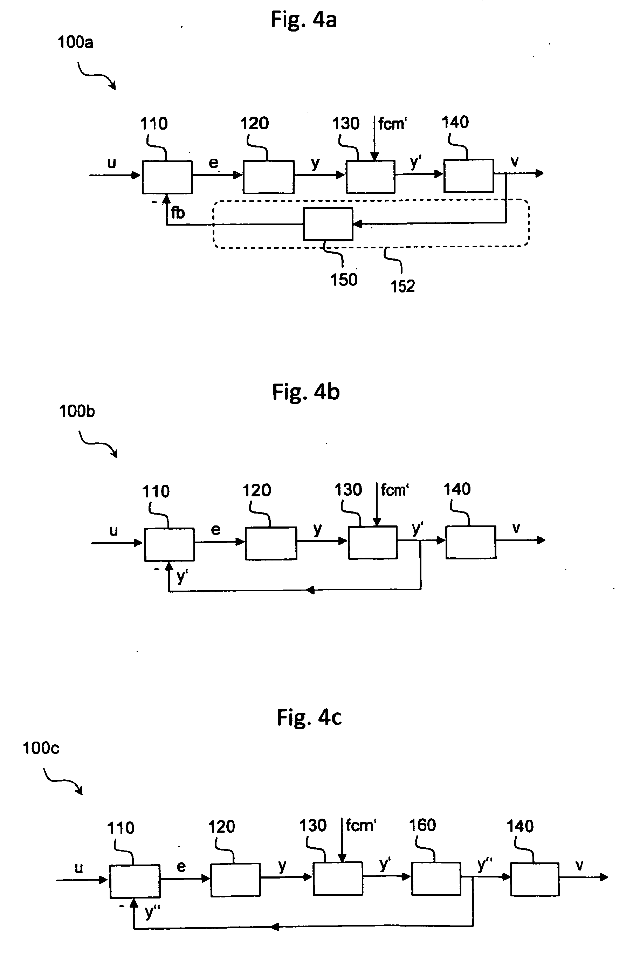

Advantageously, taking into consideration the feedback signal, which will be explained in detail further below with reference to Fig. 4a to 4c, processing errors and other disturbances (either deterministic or random) that affect signal processing in the envelope modulator 100 or components thereof, may be compensated.

In effect, the sequence of output pulses s_out comprises pulses a pulse width of which depends on both the values of the amplitude signal A and the feedback signal.

Figure 2a schematically depicts one clock cycle T_c of a carrier signal f_c_mod that can be used for the envelope modulator according to the embodiments. The clock cycle T_c ranges from a starting point T_n, representing the beginning of an n-th cycle, to an ending point T_n+1 which represents the end of the n-th cycle and the beginning of an (n+1)-th cycle, i.e. T_c = T_n+1 - T_n.

According to the present exemplary embodiment, the carrier signal f_c_mod has a basically rectangular shape, and its amplitude is depicted in arbitrary units, i.e. having two possible values (HI, LO), wherein presently the amplitude comprises a HI value from T_n to T_n + T_c/2, i.e. for duration T_c/2, and a LO value from T_n + T_c/2 to T_n+1. According to a further embodiment, the carrier signal f_c_mod may also have a non-rectangular shape. For example, it is possible to use digital signals or analog signals (e.g. sinusoidal) as a carrier signal for the operation of the envelope modulator 100 according to the embodiments.

Figure 2b schematically depicts various output pulses p1, p2, p3 that can be generated using the envelope modulator 100 (Fig. 1) according to the embodiments. The first pulse p1 has a pulse width of about T_c / 8, the second pulse p2 has a pulse width pw2 of about T_c / 4, and the third pulse p3 has a pulse width of about T_c / 2. As already explained above, the envelope modulator 100 (Fig. 1) according to the embodiments determines the pulse width of an output pulse to be generated depending on the amplitude signal A and a feedback signal.

According to a further embodiment, the pulses p1, p2, p3 are centered around a quarter T_c4 of a duration of a clock cycle T_c of said carrier signal f_c_mod (Fig. 2a). Thereby, a phase error may be avoided for varying pulse widths pw2, because the center of the output pulse p1, p2, p3 (Fig. 2b) is "locked" with respect to the phase-modulated carrier signal f_c_mod, regardless of the pulse width set by the envelope modulator.

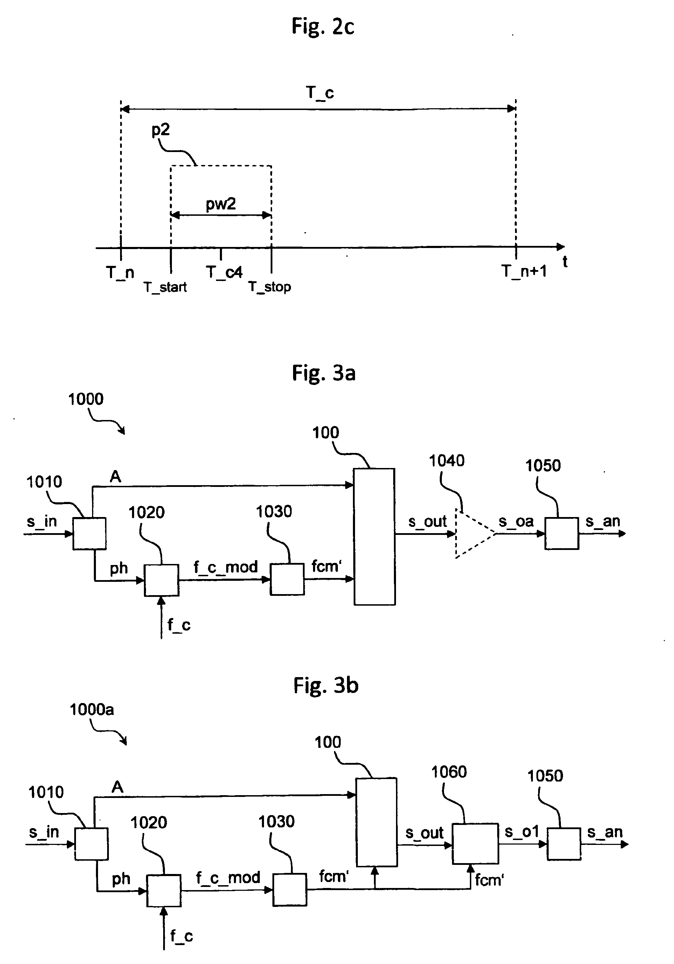

More specifically, if an output pulse p2 (Fig. 2c) is centered around said quarter T_c4 of a duration of a clock cycle T_c, said output pulse p2 starts at t = T_start = (T_n+1 - T_n) / 4 + T_n - pw2 / 2, wherein pw2 is the pulse width of said output pulse. Correspondingly, the output pulse p2 ends at t = T_stop = (T_n+1 - T_n) / 4 + T_n + pw2 / 2.

According to a further embodiment, the pulses p1, p2, p3 are not required to be centered around a specific position within the clock cycle T_c, they may rather also begin at e.g. T_n for a given n-th clock cycle T_c, i.e. at the beginning of each cycle. This may lead to a deterministic phase error due to the shift of the center of the pulse. The error is always the same for the same pulse width. Therefore it is a static amplitude to phase error (AM-PM) that can be compensated by simple means, which may be integrated into an envelope modulator according to an embodiment. One way is to introduce a phase shift in the phase branch, i.e. effecting a corresponding phase shift of the phase-modulated carrier signal dependent on the current input amplitude or selected pulse width, respectively.

Figure 3a schematically depicts a block diagram of a polar transmitter 1000 according to an embodiment. The polar transmitter 1000 receives an input signal s_in, which may e.g. be a complex-valued signal in a baseband frequency range or an intermediate frequency range. It is also possible to provide two different real-valued input signals which may be processed appropriately to yield a complex-valued signal, e.g. the first real-valued input signal simply being interpreted as an in-phase (I) component, and the second real-valued input signal being interpreted as an quadrature-phase (Q) component. Also, modulation schemes to obtain complex-valued signals from real-valued signals are known in the art.

According to a preferred embodiment, the input signal s_in is a complex-valued baseband signal, for example an analog signal being continuous in time and having continuous amplitude values. According to other embodiments, the input signal s_in may also be a digital signal, i.e. discrete in time (samples given at a predetermined sample rate) and/or value (quantization).

The polar transmitter 1000 is configured to process the input signal s_in and a carrier signal f_c so as to obtain an output signal which comprises both frequency components of the carrier signal f_c and frequency components representing the input signal. By appropriately choosing the frequency of the carrier signal f_c, e.g. to about 1 GHz, an output signal is obtained from the polar transmitter 1000 that may e.g. be used to control the operation of a switched-mode amplifier for obtaining an amplified signal within the RF range (at the carrier frequency), said amplified signal being modulated with the input signal s_in. In this context, an envelope modulator 100 according to the embodiments is used for envelope modulation of the carrier signal f_c or a phase-modulated carrier signal f_c_mod derived therefrom, respectively.

The polar transmitter 1000 comprises means 1010 for obtaining an amplitude signal A and a phase signal ph depending on said input signal s_in. Preferably, the amplitude signal A is normalized, i.e. has a value range between 0 and 1. Evidently, both the amplitude signal A and the phase signal ph are real-valued signals, i.e. only having a real component, but no imaginary component.

The amplitude signal A is directly fed to the envelope modulator 100, which generates output pulses inter alia depending on said amplitude signal A. The phase signal ph is provided to means 1020 for phase modulating a carrier signal f_c depending on said phase signal ph, whereby a phase-modulated carrier signal f_c_mod is obtained at an output of block 1020, also cf. Fig. 2a. Block 1020 may e.g. comprise a conventional phase modulator, and the carrier signal f_c may be an analog or digital signal. The phase-modulated carrier signal f_c_mod comprises information corresponding to the phase signal ph.

According to an embodiment, preferably if the carrier signal f_c is an analog signal, e.g. a sine waveform having the carrier frequency, the polar transmitter 1000 may comprise a comparator 1030 which compares an amplitude value of the phase-modulated carrier signal f_c_mod to a predetermined threshold and which outputs a binary signal fcm' that still comprises information on the phase signal ph. I.e., after the comparator 1030, the phase-modulated carrier signal fcm' is a digital signal, i.e. having a basically rectangular shape, a phase of which is modulated depending on said phase signal ph of the input signal s_in.

Instead of a discrete comparator 1030, the functionality of the comparator (i.e., providing a binary signal) may be integrated to the envelope modulator, e.g. at a respective input of the envelope modulator 100. According to a further embodiment, it is also possible to use a phase detector that is configured to detect phase changes.

The envelope modulator 100 of the polar transmitter 1000 receives both signals A, fcm' and generates for at least one clock cycle T_c (Fig. 2a) of said phase-modulated carrier signal fcm', preferably for the most or all clock cycles T_c, a respective output pulse p1, p2, p3 (Fig. 2b), wherein a pulse width of said output pulse p1, p2, p3 is determined depending on said amplitude signal A and on a feedback signal fb derived from said amplitude signal A.

I.e., the output signal s_out obtained at an output of the envelope modulator 100 comprises a sequence of pulses, a pulse width of which basically represents said amplitude signal A. Since the pulse generation within the envelope modulator 100 is synchronized with the phase-modulated carrier signal fcm', the information of the phase signal ph is also present within said output signal s_out.

According to a preferred embodiment, the output signal s_out of the envelope modulator 100 is amplified by an amplifier 1040, which may e.g. operate as class-D (switch mode amplification) amplifier, whereby an amplified output signal s_oa is obtained. The amplified output signal s_oa is provided to reconstruction filter means 1050, whereby the desired analog output signal s_an is obtained. Although representing a preferred embodiment, the amplifier 1040 is optional, i.e. may also be omitted, so that the output signal s_out may be reconstructed without amplification.

Figure 3b schematically depicts a block diagram of a polar transmitter 1000a according to a further embodiment. The components 100, 1010, 1020, 1030, 1050 have the same functions as explained above with reference to Fig. 3a.

In contrast to the Fig. 3a embodiment, the polar transmitter 1000a of Fig. 3b comprises a combiner 1060, which is preferably implemented by means of a multiplier or an AND-gate (logic operation). Thereby, the output signal s_out of the envelope modulator 100 and the phase-modulated (binary) carrier signal fcm' are combined, i.e. multiplied, whereby a corresponding output signal s_ol is obtained at an output of the combiner 1060. Optionally, an amplifier (cf. block 1040 of Fig. 3a) may be provided between the devices 1060 and 1050 of Figure 3b.

Figure 4a depicts a schematic block diagram of an envelope modulator 100a according to an embodiment. For example, the envelope modulators 100 of Fig. 1, 3a, 3b may have such internal structure.

At an input, which is not explicitly depicted by Fig. 4a, the envelope modulator 100a receives an amplitude signal u. The amplitude signal u may e.g. be identical or similar (=having identical or similar properties) to the amplitude signal A explained above with reference to Fig. 1, 3a, 3b. For example, the amplitude signal u may represent normalized amplitude values of the input signal s_in (Fig. 3a) in form of an analog signal.

The envelope modulator 100a comprises a combiner 110, preferably implemented in form of an adder, which receives as input signals the input signal u and a feedback signal fb, which is derived from said input signal u, and the generation of which will be explained in detail below. The combiner 110 may be configured to subtract the feedback signal fb from the input signal u, whereby an error signal e is obtained that may be interpreted as a measure of a deviation of the feedback signal fb from the input signal u. In other words, if the feedback signal fb is identical to the input signal u, the error signal e has a value of zero.

In a further preferred embodiment, the envelope modulator 100a comprises a filter 120, preferably a low-pass filter 120, to limit the bandwidth of the error signal e. The filter 120, which according to an embodiment may also be implemented as a digital filter, may also serve to accumulate values of the error signal e of subsequent processing cycles of the envelope modulator 100a. According to a particularly preferred embodiment, the cut-off frequency of the low-pass filter 120 is chosen such that it corresponds to the bandwidth of the amplitude signal A. Thus, in a preferred embodiment, at an output of the filter 120, a filtered error signal y is obtained the bandwidth of which is limited to a predetermined frequency, preferably to about the bandwidth of the amplitude signal A.

The envelope modulator 100a further comprises a sampling unit 130 that is configured to receive said filtered error signal y and the phase-modulated carrier signal fcm' as e.g. provided to the envelope modulator 100a by the block 1030 of the polar transmitter 1000 of Fig. 3a. The sampling unit 130, which may e.g. be implemented in the form of a sample and hold circuit, is configured to capture samples of the filtered error signal y. The points in time for capturing, i.e. sampling, the filtered error signal y are controlled by the phase-modulated carrier signal fcm'. Preferably, for each cycle of the phase-modulated carrier signal fcm', the sampling unit 130 captures one sample of the filtered error signal y, whereby a respective sampled value y' is obtained. Thus, the sampling unit 130 provides at its output samples of the filtered error signal y synchronously with the phase-modulated carrier signal fcm'. In effect, for each cycle of the phase-modulated carrier signal fcm', one sample value y' is provided by the sampling unit 130.

As an example, with a carrier frequency f_c of 1 GHz, one sample y' of the filtered error signal y is provided about every nanosecond by the sampling unit 130.

The envelope modulator 100a further comprises pulse generating means 140 that are configured to generate one or more output pulses p1, p2, p3 (Fig. 2b) depending on the samples y' provided by the sampling unit 130. The pulse generating means 140 can thus also be interpreted as a function block that transforms amplitude values, namely the samples y', into pulse widths.

As an example, with a carrier frequency f_c of 1 GHz, for each sample y' of the filtered error signal y, the pulse generating means 140 may generate an output pulse p1, p2, p3, if any. I.e., in general, the pulse generating means 140 is configured such that one output pulse per sample y' and thus per clock cycle of the phase-modulated carrier signal fcm' will be generated. However, in some embodiments, there may be operational cases where no output pulse is generated for a specific sample y'. This may e.g. apply for very small sample values and is explained in detail further below.

As a result, at the output of the pulse generator means 140, a sequence of output pulses is obtained, which represents the output signal v of the envelope modulator 100a. The output signal v of the envelope modulator 100a of Fig. 4a corresponds with the output signal s_out of the embodiments according to Fig. 1, 3a, 3b.

The rate of the output pulses of the output signal v preferably corresponds to the frequency of the phase-modulated carrier signal fcm', and a pulse width pw2 (Fig. 2b) (i.e., length) of the output pulses depends on the respective sampled value y' of a specific clock cycle of the phase-modulated carrier signal fcm'. Since y', in turn, depends on the error signal e and thus on the amplitude signal u and the feedback signal fb, the pulse width pw2 also depends on the on the amplitude signal u and the feedback signal fb.

For generating the feedback signal fb, the envelope modulator 100a of Fig. 4a comprises a feedback loop 152. According to the present embodiment, the feedback loop 152 comprises a function block 150 that receives the output signal v of the pulse generator means 140 and that is configured to transform the pulse width of the output pulses comprised within the output signal v to respective amplitude values in the form of the feedback signal fb. This advantageously enables to calculate the error signal e and thus to compensate processing errors in the envelope modulator 100a. In other words, the block 150 may be considered as comprising an inverse transfer function as compared to the block 140.

According to an embodiment, the feedback loop enables to calculate the error signal depending on the amplitude signal and on the feedback signal fb, which is derived from the amplitude signal, or , more precisely from a previous time interval of the amplitude signal. I.e., when calculating an actual value of the error signal e, the actual amplitude signal u is used and a feedback signal value that is derived from the amplitude signal of a previous processing cycle.

For example, in an ideal operational scenario, the envelope modulator 100a is supposed to generate output pulses p1, p2, p3 that precisely reflect the amplitude signal u. I.e., a pulse width pw2 (Fig. 2b) of a specific output pulse p2 should precisely reflect the corresponding sample y' characterising the value of the amplitude signal u in a specific clock cycle T_c of the phase-modulated carrier signal fcm'. However, due to various reasons, the actual pulse width as generated by the envelope modulator 100a implemented as a real system will not precisely reflect the corresponding sample y'.

Thus, advantageously, the actual pulse width, as part of the output signal v, is processed in the feedback loop 152. In block 150 of the feedback loop 152, the actual pulse width is transformed in a corresponding amplitude value, which represents the feedback signal fb. By calculating the error signal e as a difference between the signals u, fb, it is possible to compensate the above described non-ideal behaviour and thus to attain output pulses a pulse width of which rather precisely reflects the amplitude signal u.

According to a preferred embodiment, the bandwidth of the amplitude signal u is rather low as compared to the frequency f_c of the phase-modulated carrier signal fcm'. In view of this, a plurality of processing cycles of the feedback loop 152 may be executed in a specific time interval, while the amplitude signal u does not substantially change due to its much lower bandwidth. Thus, efficient error compensation by means of the feedback loop 152 is enabled. For example, as outlined above, the phase-modulated carrier signal fcm' may comprise a frequency of 1 GHz, and the bandwidth of the amplitude signal u is about 5 MHz to 10 MHz. Thus, many processing cycles of the feedback loop 152 may be performed while the amplitude signal u is substantially constant, so that iteratively output pulse widths can be provided which reflect the amplitude signal u with a high precision. In other words, the amplitude signal u may be considered to be constant during one clock cycle T_c of the phase-modulated carrier signal fcm'.

Generally, the feedback loop 152 advantageously allows to compensate errors regarding the output pulse width which may be caused by any component of the envelope modulator 100a.

According to a further embodiment, the feedback loop 152 may also comprise a bandpass filter and an envelope detector to generate a feedback signal fb. The bandpass filter is preferably configured such that it passes the inband signal and eliminates all other frequency components, especially around DC (direct current) and around n * f_c, where n = 2 .. infinity.

Fig. 4b depicts a further embodiment 100b of an envelope modulator. In difference to the embodiment 100a of Fig. 4a, the envelope modulator 100b of Figure 4b comprises a feedback loop that receives the sample values y', instead of the output pulses v. This is advantageous if the errors that may result from processing in block 140 (pulse generator) are acceptably small or if there are no errors at all introduced by processing in block 140. In this case, per clock cycle T_c, a corresponding sample value y' as captured by the sampling unit 130 is returned by the feedback loop to the adder 110, which determines the error signal e as e = u - y'. For instance, if the sampling unit 130 comprises an analog to digital converter, ADC, (not shown), quantization errors depending on the resolution of the ADC are introduced for the sample y'. In this case, the feedback mechanism of Fig. 4b enables to compensate these quantization errors. Errors of further components 120, 130 may also be compensated by the feedback mechanism of Fig. 4b.

With the feedback structure of Fig. 4b, imperfections of the block 140 cannot be compensated anymore, because it is not included in the feedback loop. If these imperfections are static or varying comparatively slowly this issue can be compensated by a calibration routine (not shown).

Fig. 4c depicts a further envelope modulator 100c according to an embodiment. In difference to the embodiments 100a, 100b explained above, an amplitude conditioning block 160 is present which enables to modify the amplitude of the samples y', whereby modified samples y" are obtained and forwarded to the pulse generator means 140. Thus, the pulse width of the output pulses may be modified by implementing a respective transfer function of said amplitude conditioning block 160.

For example, according to an embodiment, the amplitude conditioning block 160 can be used for implementing a mechanism that limits the minimum pulse width of output pulses to be generated by the pulse generator means 140. This is beneficial in view of the fact that e.g. switching semiconductors such as field effect transistors of a switching amplifier (cf. reference numeral 1040 of Fig. 3a) are controlled by the output signal s_out or v of the envelope modulator 100c, because these switching semiconductors cannot conduct respective switching operations with very high frequencies and at the same time high precision. Thus, the minimum pulse width of output pulses to be generated by the pulse generator means 140 may be limited to a value which ensures that said switching semiconductors can follow their control signal v with sufficient precision. If, nevertheless, the amplitude signal u comprises very small values, which would result in pulse widths below the predetermined minimum pulse width, the envelope modulator 100c can omit pulse generation for the respective cycle(s) T_c. In this case, block 160 of Fig. 4c may determine that a sample value y' is too low (i.e., would result in an output pulse with a too small pulse width), and block 160 may output a zero value for said sample value y', so that the pulse generator means 140 do not generate an output pulse at all. Advantageously, this zero value of signal y" is fed back and contributes to the determination of the error signal e so that the error introduced by deliberate omission of a specific (too short) output pulse may be compensated for subsequent processing cycles T_c.

According to a further embodiment, the amplitude conditioning block 160 may be used for quantization of the sample value y'. Thus, the sample value y' may be transformed to a quantized sample value y" with a predetermined precision/resolution. For example, the amplitude conditioning block 160 may be configured such that - for the whole amplitude range, e.g. 0 to 1 - only a predetermined number of different discrete (quantized) amplitude values y" is output, so that y" may e.g. only assume four different values or e.g. sixteen different values, which leads to a correspondingly limited number of possible pulse widths for the output pulses as generated by block 140 that receives the quantized amplitude values y" as an input signal. According to an embodiment, equidistant pulse widths are provided, which is particularly easy to realize with digital circuits.

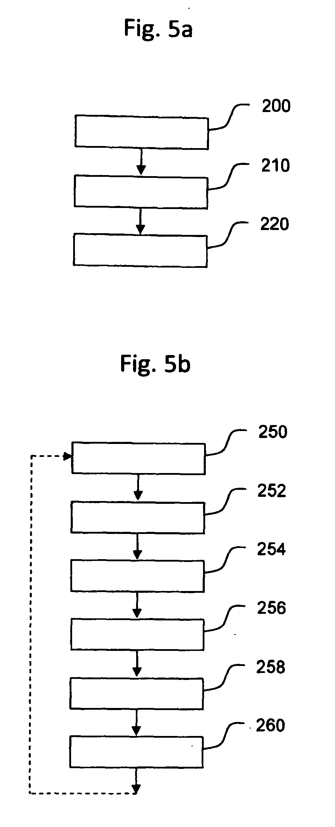

Figure 5a depicts a simplified flow chart of a method according to an embodiment. In a first step 200, an envelope modulator 100, 100a, .. according to the embodiments receives an amplitude signal A, u (Fig. 1, 4a). The amplitude signal A, u may e.g. be provided by block 1010 of a polar transmitter 1000 as depicted by Fig. 3a. In subsequent step 210, the envelope modulator determines a pulse width of an output pulse p1, p2, p3, which is to be generated within a clock cycle T_c (Fig. 2b), depending on said amplitude signal A, u and on a feedback signal fb (Fig. 4a) derived from said amplitude signal A. With the embodiments 100b, 100c according to Fig. 4b and 4c, the signals y', y" are used as feedback signals instead. After that, in step 220 (Fig. 5a), the envelope modulator outputs an output pulse with the pulse width as determined in step 210.

Figure 5b depicts a simplified flow chart of a method according to a further embodiment. In step 250, the envelope modulator 100a (Fig. 4a) receives an amplitude signal u. In step 252, the combiner (e.g., adder) 110 subtracts the feedback signal fb from the input signal u, whereby the error signal e is obtained. In step 254, low-pass filtering of the error signal e is performed, whereby the filtered error signal y is obtained. In step 256, a sample of the filtered error signal y is captured by sampling unit 130 (Fig. 4a) synchronously with the phase-modulated carrier signal fcm', whereby a respective sampled value y' is obtained. In step 258, the pulse generator means 140 generate an output pulse p2 (Fig. 2b) with a pulse width pw2 that depends on the sampled value y' and thus depends on said amplitude signal u and said feedback signal fb. The output pulse p2 constitutes a part of the envelope modulator's output signal v, which is fed back in step 260 by means of the feedback loop 152 to the adder 110.

According to one embodiment, the steps 250 to 260 explained above with reference to the flow chart of Fig. 5b are performed once each for one clock cycle $T\_c$ of the phase-modulated carrier signal fcm'. The exact duration of a clock cycle $T\_c$ of the phase-modulated carrier signal fcm' may slightly vary each clock cycle $T\_c$ since it is dependent on the current phase value of the phase signal ph (Fig. 3a). Thus, for each clock cycle $T\_c$, an output pulse is generated by block 140 (Fig. 4a) - if any.

In other words, preferably, the envelope modulator is clocked by the phase-modulated carrier signal fcm'. Preferably, the clocking - in average - happens only once per carrier period ($T\_c = 1 / f\_c$), e. g. on the rising or falling edge of the phase-modulated carrier signal fcm'. Thus state changes of the envelope modulator are synchronous to output signal v, s_out.

According to a further embodiment, the envelope modulator 100, 100a, 100b, 100c is configured to generate output pulses p1, p2, p3 with two or more different pulse widths pw2 (Fig. 2b). It is particularly preferred if the envelope modulator is configured to generate a large number of different pulse widths, whereby linearity and coding efficiency is advantageously increased. According to another embodiment, the number of pulses with different pulse width can be increased adaptively, i.e. dynamically, to meet the requirements for different scenarios (e.g. change of carrier frequency, change of signal bandwidth, and the like).

According to another embodiment, the envelope modulator may be configured to provide only a comparatively small number of different output pulse widths, which simplifies the generation of said output pulses. For example, according to an embodiment, the envelope modulator may be configured to provide four different pulse widths only. For this purpose, a respective quantization of the sample value(s) y' (Fig. 4a) may be performed, for example such that there are only four possible sample values, each of which leads to a specific pulse width.

According to another embodiment, said pulse generated by the pulse generator means 140 (Fig. 4a) is approximately a rectangular pulse, the rectangular form being quite simple to establish with digital signal processing components so that pulse generation can be effected very efficiently. According to another embodiment, the output pulses are symmetric along a time coordinate.

Other embodiments are also possible, where one or more of the following features characterize the output pulses: non-rectangular pulse shape, binary amplitude levels (low and high), n-ary amplitude levels (n > 2, i.e. more than two amplitude levels for the output pulses.

According to an embodiment, binary output pulses of desired pulse width may be generated by using a transformation of the sample value y' to the pulse width by means of a table or the like. For example, a parallel to serial convertor may be used that receives as an input signal a data word (parallel data) corresponding to the sample value y', and that outputs a pulse shape or pulse a pulse width of which corresponds to the sample value y'. Such functionality as well as any other component of the envelope modulator according to the embodiments may e.g. be implemented in form of a digital signal processor (DSP) hardware, application specific integrated circuit (ASIC), field programmable gate array (FPGA) or the like. Particularly, a high speed serial link or interface of an ASIC may advantageously be employed to generate said output pulses according to an embodiment. In this respect, the high speed serial link or interface of an ASIC is controlled such that it outputs the required amplitude levels for the required durations, i.e. pulse width and the phases where no pulse is present.

Likewise, single or all components of the envelope modulator according to the embodiments may e.g. be implemented by analog circuitry. A combination of analog and digital components is also possible to implement the envelope modulator according to the embodiments. Particularly, the components 110 to 160 may be implemented by analog and/or digital circuitry or any combination thereof. The low-pass filter 110 may be of first order or of higher order.

The envelope modulator according to the embodiments offers improved performance with respect to conventional systems, especially in terms of coding efficiency and linearity.

In contrast, conventional systems based on delta sigma modulation (DSM) suffer from low spectral purity (wideband noise), limited coding efficiency, limited usable bandwidth, high sampling frequencies (>4*f_c) and limited linearity. Also, conventional systems based on RF-PWM (radio frequency pulse width modulation) suffer from the requirement of infinite small pulse widths that cannot be generated efficiently by transistor technology for higher frequency ranges, e. g. in the area of 900MHz to 2.6GHz for mobile communication applications.

The main advantages of the envelope modulator according to the embodiments are: low requirements of sampling frequency, low complexity, possibility of digital implementation, pulse skipping (= omitting output pulse generation for very small input amplitudes), flexibility of trading pros and cons of conventional systems, pulse width variation and high efficiency, which leads to a versatile, adaptive and efficient solution. Particularly, a threshold value for the minimum possible pulse width may dynamically be changed, i.e. even during operation of the system.

According to a further preferred embodiment, the envelope modulator according to the embodiments generates output pulses with a pulse width of 0 to T_c / 2, wherein said output pulses represent the sampled amplitude y' of the amplitude signal u. Other maximum pulse widths, i.e. > T_c / 2 are also possible for some embodiments.

According to a further embodiment, the envelope modulator 100, 100a, 100b, 100c is configured to, preferably at least approximately, determine the pulse width pw2 (Fig. 2b) of the output pulses depending on the following equation:

$$PW = c1 * arcsin(y'(t)),$$

wherein PW represents said pulse width, wherein c1 represents a first constant, wherein arcsin() represents the inverse sine function, and wherein y'(t) represents a signal derived from a difference between said amplitude signal and said feedback signal. E.g., y'(t) may correspond with the sampled value y' of Fig. 4a. For example, in one embodiment, the first constant c1 may be chosen according to: c1 = Tc/Pi, wherein Tc represents the cycle time T_c (Fig. 2a) of the carrier signal, i.e. Tc = 1 / fc (fc is the frequency of the carrier signal), and Pi ($\pi$) = 3.141...

Instead of the above equation, according to another embodiment, any mapping function may be used, that may e.g. also be based on training. The above equation is a preferred mapping function for mapping of y' to PW in case of ideal rectangular output. Given non-ideal components it may be beneficial to start with a mapping as defined by the above equation PW = ... and to collect the values obtained by evaluation of said equation in a table and "train", i.e. refine, them to be more accurate thus accounting for non-ideal components. A fixed table may of course also be used for mapping the amplitude signal or y', respectively, to a pulse width PW.

According to a further embodiment, the envelope modulator is configured to compare said determined pulse width of said output pulse with a predetermined threshold value, and to not output said output pulse if said determined pulse width is smaller than said predetermined threshold value (=limitation of small pulse widths). I.e., in this embodiment, the envelope modulator is not required to generate an output pulse for each clock cycle T_c (this yields a pulse rate < 1.0). Especially for very small values of the amplitude signal A, u, where rather small pulse widths would be required for the output pulses, the desired small pulse widths might be difficult or impossible to obtain within a real implementation with sufficient precision. This is e.g. due to finite switching times of switching transistors that may be used in a class-D amplifier 1040 (Fig. 3a) that is controlled with the output signal s_out of the envelope modulator 100 according to the embodiments. In these cases, according to the present embodiment, no output pulse is generated. A potential error that may result from not outputting any pulse instead of a rather short output pulse may advantageously be compensated by the feedback mechanism 152 (Fig. 4a) according to the embodiments.

For example, the predetermined threshold value for the minimum pulse width to be generated may be chosen depending on the technology (CMOS, ..) and implementation details of the envelope modulator. Preferably, the predetermined threshold value is chosen such that pulse widths that correspond with the predetermined threshold value may be generated with sufficient precision. If the envelope modulator determines that pulse widths smaller than the predetermined threshold value are required, i.e. because of small amplitude signal values, the envelope modulator does not output any output pulse in the corresponding clock cycle T_c of the phase-modulated carrier signal. In this case, a suboptimal approximation of the amplitude signal A, u is tolerated, and the corresponding error may be compensated during the subsequent clock cycles by the feedback signal fb, y', y'', that is also considered for pulse width determination according to the embodiments.

According to a further embodiment, a predistortion mechanism can be provided either for the envelope modulator 100 only or for the transmitter 1000 as a whole. One possible setup is:

1. a copy of the output (i.e.: s_out filtered with bandpass, s_o1 -> filtered with bandpass, s_oa -> splitter that outputs a e.g. 1% of s_oa -> bandpass filter, s_an -> splitter that outputs a e.g. 1% of s_oa) of the system is mixed down by the input frequency (carrier signal without phase modulation) or processed such that the envelope of the modulated signal at carrier frequency is determined (Fig. 3a),

2. A copy of the envelope signal after amplifier and filter can also be used as feedback signal fb of the feedback loop of the envelope modulator,

3. The inverse of the averaged input amplitude to output amplitude function is applied to the input signal. And the inverse of the averaged input phase to output phase function is applied to the input signal. In addition the time dependent characteristic can be compensated by DPDs (digital predistortion) with memory.

The envelope modulator according to the embodiments enables highly efficient modulation that is suitable for realistic switch mode amplifier implementations. It solves the problem of short pulses (small pulse width) that conventional RF-PWM (pulse width modulation) generally suffers from and allows very good signal quality of the output signal s_an (Fig. 3a). At the same time, the envelope modulator according to the embodiments does not suffer from the typical problems of delta-sigma modulators.

Particular advantages of the envelope modulator according to the embodiments are spectral purity of the output signal (less filter requirements), higher coding efficiency (higher power efficiency->less power consumption), suitability for wideband systems beyond 5MHz bandwidth of the input signal s_in (Fig. 3a), less pulses (pulse rate < 1 for the embodiments with predetermined minimum pulse width) and thus less switching losses, better energy efficiency in back-off operation. The system and method according to the embodiments is very well scalable e.g. regarding signal quality and minimum pulse width.

According to a further preferred embodiment, the clock signal f_c (Fig. 3a) is an analog signal and the phase modulation of block 1020 is performed in the analog domain, which has the advantage that no quantization errors are introduced when generating the phase-modulated carrier signal f_c_mod.

According to a further embodiment, the pulse generator means 140 may be configured to generate output pulses with more than two possible amplitude levels, e.g. three (ternary signal) or more levels. Ternary signals may advantageously be generated from binary signals by means of signal inversion and superposition of inverted and noninverted signal components, wherein inverted and noninverted signal components may be delayed with respect to each other (e.g. for ternary signals by a delay of 180° at the carrier frequency f_c ). By providing ternary or n-ary (n>3) signals, the coding efficiency may be further improved. Advantageously, passive structures such as delay lines may be employed to provide said ternary signals for the output pulses.

According to a further advantageous embodiment, the pulse generator means 140 may be configured to generate output pulses with predetermined, limited bandwidth, which can e.g. be accomplished by providing only a predetermined number of harmonics for shaping said output pulses (in contrast to strict rectangular pulses comprising numerous higher harmonics with nonvanishing amplitude). This accounts for the limited bandwidth of subsequent components such as the amplifier 1040 (Fig. 3a) and helps to reduce distortions and noise thus increasing signal quality of the output signal s_out, v.

According to a further embodiment, it is possible to provide a modified amplitude signal to the input of the envelope modulator, i.e. arcsin(u) instead of u, which helps to avoid the implementation of the arcsin() function according to some embodiments within the pulse generator 140. In this embodiment, the pulse generator 140 may implement a linear function that transforms the sample y' to a corresponding pulse width. Depending on the implementation, this may lead to a simplified and less complex structure. The implementation of the arcsin() function may be accomplished by analog or digital signal processing, e.g. a corresponding function block at an input of the envelope modulator or a look-up table. Alternatively, the implementation of the arcsin() function may also be provided within the function block 1010 (Fig. 3a) of the polar transmitter 1000, which is beneficial since block 1010 already comprises signal processing capabilities for separating the complex input signal s_in into an amplitude signal A and a phase signal ph. Thus, according to an embodiment, block 1010 could be modified to output arcsin(A) instead of A.

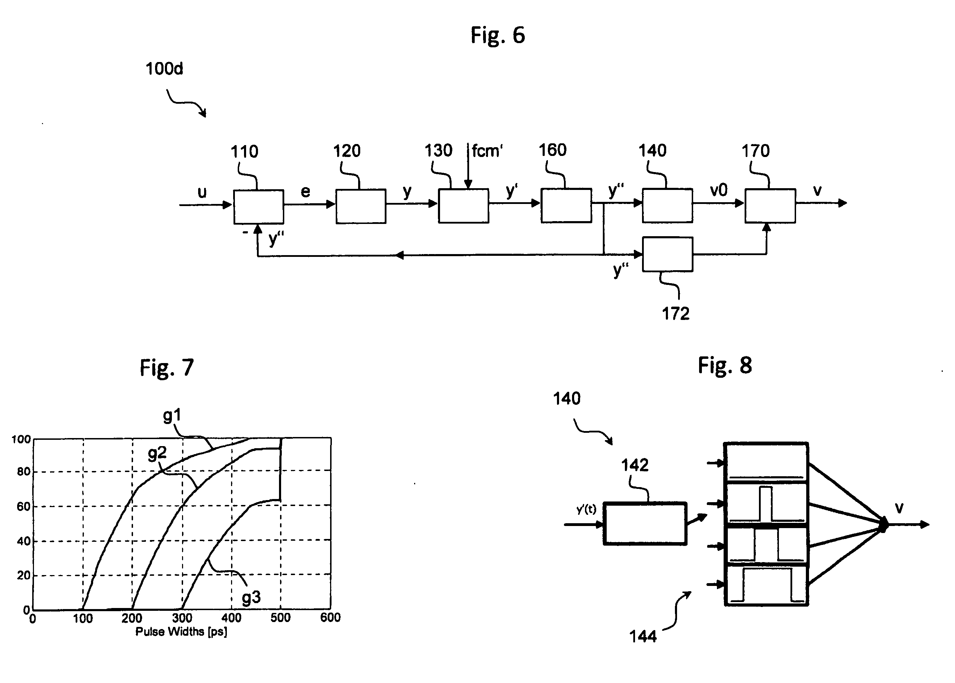

Fig. 6 depicts a schematic block diagram of an envelope modulator 100d according to a further embodiment. The structure and function of envelope modulator 100d is similar to the one of envelope modulator 100c of Fig. 4c. However, the pulse generator means 140 of Fig. 6 may be configured to generate output pulses v0 that are not centered around T_c4 (Fig. 2b), but that begin at T_n, i.e. with the very beginning of the clock cycle T_c which may introduce a phase error. However, with this embodiment, pulse generation is simplified in contrast to the centered pulses of Fig. 2b. To compensate the phase error, phase shifter means 170 are provided that provide a phase shift of the output pulses v0 to e.g. the position T_c4 in the clock cycle T_c. For this purpose, the phase shifter means 170 are controlled by block 172 that receives a sample y" of the amplitude signal and that transforms said sample y" into a control signal indicating the required phase shift for obtaining correctly centered output pulses v from the output pulses v0. The phase shifter means 170 may also comprise programmable delay means and the like, or the phase shifter may be controlled by a control signal generated by an outer control loop that evaluates e.g. the amplified and filtered signal s_an.

Fig. 7 depicts a graph with three curves g1, g2, g3, which indicate a cumulative probability of pulse widths of output pulses generated by an envelope modulator according to the embodiments. The horizontal axis denotes the pulse width in picoseconds, and the vertical axis denotes a probability in percent that the pulse width is less or equal to the corresponding value of the horizontal axis. For this graph, it is assumed that a clock cycle T_c is 1 nanosecond, i.e. 1000 picoseconds, which corresponds to a carrier frequency of 1 GHz. It can be seen that the maximum pulse width for each curve g1, g2, g3 is 500 ps, which corresponds to T_c / 2. For the scenario of curve g1, it is assumed that a minimum output pulse width (threshold value) has been limited to 100 ps, i.e. if there are low input amplitude values, which would require pulse widths shorter than 100 ps, no output pulse is generated in a specific cycle. The resulting error is fed back by the feedback loop 152 as explained above. For the scenario of curve g2, it is assumed that a minimum output pulse width has been limited to 200 ps, and for the scenario of curve g3, it is assumed that a minimum output pulse width has been limited to 300 ps.

Figure 8 depicts a schematic block diagram of pulse generator means 140 according to an embodiment. As can be seen, a number of different pulse generators 144 are provided each of which is configured to generate an output pulse with a specific pulse width, or not output pulse. Selection means 142 receive the sample signal y'(t) and determine based on said sample signal y'(t) which pulse generator 144 to activate in order to select an appropriate pulse width for the output pulse v.

The concept depicted by Fig. 8 may also be referred to as "quantized pulse widths", because it generates pulses that are fractions F of T_c / 2 long to represent the sampled amplitude y'. The number of different fractions can be as high as possible so that the system approaches a system with quasi-continuous pulse widths.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

The functions of the various elements shown in the FIGs., including any functional blocks labelled as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or 'controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the FIGS. are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. Envelope modulator (100, 100a, 100b, 100c), particularly for a polar transmitter (1000), wherein said envelope modulator (100) is configured to receive an amplitude signal (A, u) and a phase-modulated carrier signal (f_c_mod, fcm'), and to output for at least one clock cycle (T_c) of said phase-modulated carrier signal (f_c_mod, fcm') an output pulse (p1, p2, p3), wherein a pulse width of said output pulse (p1, p2, p3) is determined depending on said amplitude signal (A) and on a feedback signal (fb) derived from said amplitude signal (A), wherein said envelope modulator (100) is configured to compare said determined pulse width (pw2) of said output pulse (p2) with a predetermined threshold value, and to_not output said output pulse (p2) if said determined pulse width (pw2) is smaller than said predetermined threshold value.

2. Envelope modulator (100) according to claim 1, wherein said envelope modulator (100) is configured to generate output pulses (p1, p2, p3) with two or more different pulse widths (pw2).

3. Envelope modulator (100) according to at least one of the preceding claims, wherein said pulse (p1, p2, p3) is approximately a rectangular pulse.

4. Envelope modulator (100) according to at least one of the preceding claims, wherein said pulse (p1, p2, p3) is centered around a quarter (T_c4) of a duration of a clock cycle (T_c) of said carrier signal (f_c_mod).

5. Envelope modulator (100) according to at least one of the preceding claims, wherein said pulse width is, preferably at least approximately, determined depending on the following equation: $PW = c1 * arcsin(y'(t))$, wherein PW represents said pulse width, wherein c1 represents a first constant, wherein arcsin() represents the inverse sine function, and wherein y'(t) represents a signal derived from a difference (e) between said amplitude signal (A) and said feedback signal.

6. Envelope modulator (100, 100a) according to at least one of the preceding claims, wherein said envelope modulator (100) comprises a sampling unit (130) that is configured to receive said phase-modulated carrier signal (f_c_mod, fcm') and to capture, synchronously with said phase-modulated carrier signal (f_c_mod, fcm'), a) a sample (y') of said amplitude signal (A, u) or b) a sample (y') of a signal (e, y) derived from said amplitude signal (A, u).

7. Envelope modulator (100, 100a) according to at least one of the preceding claims, wherein said envelope modulator (100) comprises a feedback loop (152) for providing said feedback signal (fb) and a combiner (110), preferably adder (110), which combines said amplitude signal (A, u) and said feedback signal (fb) to obtain an error signal (e).

8. Envelope modulator (100, 100a) according to at least one of the preceding claims, wherein said envelope modulator (100) comprises pulse generating means (140) that are configured to generate one or more output pulses (p1, p2, p3).

9. Polar transmitter (1000) comprising an envelope modulator (100, 100a, 100b, 100c) according to one of the preceding claims, wherein said polar transmitter (1000) further comprises means (1010) for obtaining an amplitude signal (A, u) and a phase signal (ph) depending on an input signal (s_in), means (1020) for phase modulating a carrier signal (f_c) depending on said phase signal (ph) to obtain a phase-modulated carrier signal (f_c_mod, fcm'), and wherein said polar transmitter (1000) is configured to provide said amplitude signal (A, u) and said phase-modulated carrier signal (f_c_mod, fcm') to said envelope modulator (100, 100a, 100b, 100c).

10. Method of operating an envelope modulator (100, 100a, 100b, 100c), particularly for a polar transmitter (1000), wherein said envelope modulator (100) is configured to receive an amplitude signal (A, u) and a phase-modulated carrier signal (f_c_mod, fcm'), wherein said envelope modulator outputs for at least one clock cycle (T_c) of said phase-modulated carrier signal (f_c_mod, fcm') an output pulse (p1, p2, p3), wherein a pulse width of said output pulse (p1, p2, p3) is determined depending on said amplitude signal (A) and on a feedback signal (fb) derived from said amplitude signal (A), wherein said envelope modulator (100) compares said determined pulse width (pw2) of said output pulse (p2) with a predetermined threshold value, and wherein said envelope modulator (100) does not output said output pulse (p2) if said determined pulse width (pw2) is smaller than said predetermined threshold value.

11. Method according to claim 10, wherein said envelope modulator (100) generates output pulses (p1, p2, p3) with two or more different pulse widths (pw2).

12. Method according to at least one of the claims 10 to 11, wherein said pulse width is, preferably at least approximately, determined depending on the following equation: PW = c1 * arcsin(y'(t)), wherein PW represents said pulse width, wherein c1 represents a first constant, wherein arcsin() represents the inverse sine function, and wherein y'(t) represents a signal derived from a difference (e) between said amplitude signal (A) and said feedback signal (fb).

13. Method according to at least one of the claims 10 to 12, wherein said envelope modulator (100) generates output pulses (p1, p2, p3) with two or more different amplitude levels.

**Patentansprüche**

1. Hüllkurvenmodulator (100, 100a, 100b, 100c), insbesondere für einen Polar-Sender (1000), wobei der besagte Hüllkurvenmodulator (100) für den Empfang eines Amplitudensignals (A, u) und eines phasenmodulierten Trägersignals (f_c_mod, fcm') und für die Ausgabe, für zumindest einen Taktzyklus (T_c) des besagten phasenmodulierten Trägersignals (f_c_mod, fcm'), eines Ausgangspulses (p1, p2, p3) konfiguriert ist, wobei eine Pulsweite des besagten Ausgangspulses (p1, p2, p3) in Abhängigkeit von dem besagten Amplitudensignal (A) und von einem von dem besagten Amplitudensignal abgeleiteten Rückkopplungssignal (fb) ermittelt wird, wobei der besagte Hüllkurvenmodulator (100) dafür konfiguriert ist, die besagte ermittelte Pulsweide (pw2) des besagten Ausgangspulses (p2) mit einem vorbestimmten Grenzwert zu vergleichen und den besagten Ausgangspuls (p2) nicht auszugeben, wenn die besagte ermittelte Pulsweite (pw2) kleiner als der besagte vorbestimmte Grenzwert ist.

2. Hüllkurvenmodulator (100) nach Anspruch 1, wobei der besagte Hüllkurvenmodulator (100) für das Erzeugen von Ausgangspulsen (p1, p2, p3) mit zwei oder mehr unterschiedlichen Pulsweiten (pw2) konfiguriert ist.

3. Hüllkurvenmodulator (100) nach mindestens einem der vorstehenden Ansprüche, wobei der besagte Puls (p1, p2, p3) ein annähernd rechteckförmiger Puls ist.

4. Hüllkurvenmodulator (100) nach mindestens einem der vorstehenden Ansprüche, wobei der besagte Puls (p1, p2, p3) um ein Viertel (T_c4) einer Dauer eines Taktzyklus (T_c) des besagten Trägersignals (f_c_mod) zentriert ist.

5. Hüllkurvenmodulator (100) nach mindestens einem der vorstehenden Ansprüche, wobei die besagte Pulsweite zumindest annähernd in Abhängigkeit von der folgenden Gleichung ermittelt wird: PW = c1 * arcsin (y' (t)) ermittelt wird, wobei PW die besagte Pulsweite darstellt, wobei c1 eine erste Konstante darstellt, wobei arcsin () die inverse Sinusfunktion darstellt, und wobei y' (t) ein von einer Differenz (e) zwischen dem besagten Amplitudensignal (A) und dem besagten Rückkopplungssignal abgeleitetes Signal darstellt.

6. Hüllkurvenmodulator (100, 100a) nach mindestens einem der vorstehenden Ansprüche, wobei der besagte Hülskurvenmodulator (100) eine Abtasteinheit (130) umfasst, welche für den Empfang des besagten phasenmodulierten Trägersignals (f_c_mod, fcm') und für die Erfassung, synchron mit dem besagten phasenmodulierten Trägersignal (f_c_mod, fcm'), a) eines Abtastwertes (y') des besagten Amplitudensignals (A, u) oder b) eines Abtastwertes (y') eines von dem besagten Amplitudensignal (A, u) abgeleiteten Signals (e, y) konfiguriert ist.

7. Hüllkurvenmodulator (100, 100a) nach mindestens einem der vorstehenden Ansprüche, wobei der besagte Hüllkurvenmodulator (100) eine Rückkopplungsschleife (152) zur Bereitstellung des besagten Rückkopplungssignals (fb) und einen Kombinator (110), vorzugsweise einen Addierer, welcher das besagte Amplitudensignal (A, u) und das besagte Rückkopplungssignal (fb) kombiniert, um ein Fehlersignal (e) zu erhalten, umfasst.

8. Hüllkurvenmodulator (100, 100a) nach mindestens einem der vorstehenden Ansprüche, wobei der besagte Hüllkurvenmodulator (100) Pulserzeugungsmittel (140) umfasst, welche für die Erzeugung eines oder mehrerer Ausgangspulse (p1, p2, p3) konfiguriert sind.

9. Polar-Sender (1000), umfassend einen Hüllkurvenmodulator (100, 100a, 100b, 100c) gemäß einem der vorstehenden Ansprüche, wobei der besagte Polar-Sender (1000) weiterhin Mittel (1010) zum Erhalten eines Amplitudensignals (A, u) und eines Phasensignals (ph) in Abhängigkeit von einem Eingangssignal (s_in), und Mittel (1020) zum Phasenmodulieren eines Trägersignals (f_c) in Abhängigkeit von dem besagten Phasensignal (ph), um ein phasenmoduliertes Trägersignal (f_c_mod, fcm') zu erhalten, umfasst, und wobei der besagte Polar-Sender (1000) für die Bereitstellung des besagten Amplitudensignals (A, u) und des besagten phasenmodulierten Trägersignals (f_c_mod, fcm') an den besagten Hüllkurvenmodulator (100, 100a, 100b, 100c) konfiguriert ist.

10. Verfahren zum Betreiben eines Hüllkurvenmodulators (100, 100a, 100b, 100c), insbesondere für einen Polar-Sender (1000), wobei der besagte Hüllkurvenmodulator (100) für den Empfang eines Amplitudensignals (A, u) und eines phasenmodulierten Trägersignals (f_c_mod, fcm') konfiguriert ist, wobei der besagte Hüllkurvenmodulator für zumindest einen Taktzyklus (T_c) des besagten phasenmodulierten Trägersignals (f_c_mod, fcm') einen Ausgangspuls (p1, p2, p3) ausgibt, wobei eine Pulsweite des besagten Ausgangspulses (p1, p2, p3) in Abhängigkeit von dem besagten Amplitudensignal (A) und von einem von dem besagten Amplitudensignal (A) abgeleiteten Rückkopplungssignal (fb) ermittelt wird, wobei der besagte Hüllkurvenmodulator (100) die besagte ermittelte Pulsweide (pw2) des besagten Ausgangspulses (p2) mit einem vorbestimmten Grenzwert vergleicht, und wobei der besagte Hüllkurvenmodulator (100) den besagten Ausgangspuls (p2) nicht ausgibt, wenn die besagte ermittelte Pulsweite (pw2) kleiner als der besagte vorbestimmte Grenzwert ist.

11. Verfahren nach Anspruch 10, wobei der besagte Hüllkurvenmodulator (100) Ausgangspulse (p1, p2, p3) mit zwei oder mehr unterschiedlichen Pulsweiten (pw2) erzeugt.

12. Verfahren nach mindestens einem der Ansprüche 10 bis 11, wobei die besagte Pulsweite zumindest annähernd in Abhängigkeit von der folgenden Gleichung ermittelt wird: PW = c1 * arcsin (y' (t)) ermittelt wird, wobei PW die besagte Pulsweite darstellt, wobei c1 eine erste Konstante darstellt, wobei arcsin () die inverse Sinusfunktion darstellt, und wobei y' (t) ein von einer Differenz (e) zwischen dem besagten Amplitudensignal (A) und dem besagten Rückkopplungssignal (fb) abgeleitetes Signal darstellt.

13. Verfahren nach mindestens einem der Ansprüche 10 bis 12, wobei der besagte Hüllkurvenmodulator (100) Ausgangspulse (p1, p2, p3) mit zwei oder mehr unterschiedlichen Amplitudenpegel erzeugt.

**Revendications**

1. Modulateur d'enveloppe (100, 100a, 100b, 100c), en particulier pour un émetteur polaire (1000), ledit modulateur d'enveloppe (100) étant configuré pour recevoir un signal d'amplitude (A, u) et un signal porteur modulé en phase (f_c_mod, fcm') et pour délivrer en sortie pendant au moins un cycle d'horloge (T_c) dudit signal porteur modulé en phase (f_c_mod, fcm') une impulsion de sortie (p1, p2, p3), dans lequel une largeur d'impulsion de ladite impulsion de sortie (p1, p2, p3) est déterminée en fonction dudit signal d'amplitude (A) et d'un signal de rétroaction (fb) dérivé dudit signal d'amplitude (A), ledit modulateur d'enveloppe (100) étant configuré pour comparer ladite largeur d'impulsion déterminée (pw2) de ladite impulsion de sortie (p2) à une valeur de seuil prédéterminée et pour ne pas délivrer en sortie ladite impulsion de sortie (p2) si ladite largeur d'impulsion déterminée (pw2) est inférieure à ladite valeur de seuil prédéterminée.

2. Modulateur d'enveloppe (100) selon la revendication 1, ledit modulateur d'enveloppe (100) étant configuré pour générer des impulsions de sortie (p1, p2, p3) avec au moins deux largeurs d'impulsion différentes (pw2).

3. Modulateur d'enveloppe (100) selon au moins une des revendications précédentes, dans lequel ladite impulsion (p1, p2, p3) est approximativement une impulsion rectangulaire.

4. Modulateur d'enveloppe (100) selon au moins une des revendications précédentes, dans lequel ladite impulsion (p1, p2, p3) est centrée sur un quart (T_c4) d'une durée d'un cycle d'horloge (T_c) dudit signal porteur (f_c_mod).

5. Modulateur d'enveloppe (100) selon au moins une des revendications précédentes, dans lequel ladite largeur d'impulsion est, de préférence au moins approximativement, déterminée en fonction de l'équation suivante : PW = c1 * arc-sinus (y' (t)), dans laquelle PW représente ladite largeur d'impulsion, dans laquelle c1 représente une première constante, dans laquelle arc-sinus() représente la fonction inverse du sinus et dans laquelle y' (t) représente un signal dérivé d'une différence (e) entre ledit signal d'amplitude (A) et ledit signal de rétroaction.

6. Modulateur d'enveloppe (100, 100a) selon au moins une des revendications précédentes, ledit modulateur d'enveloppe (100) comprenant une unité d'échantillonnage (130) qui est configurée pour recevoir ledit signal porteur modulé en phase (f_c_mod, fcm') et pour capturer, de manière synchrone avec ledit signal porteur modulé en phase (f_c_mod, fcm'), a) un échantillon (y') dudit signal d'amplitude (A, u) ou b) un échantillon (y') d'un signal (e, y) dérivé dudit signal d'amplitude (A, U)

7. Modulateur d'enveloppe (100, 100a) selon au moins une des revendications précédentes, ledit modulateur d'enveloppe (100) comprenant une boucle de rétroaction (152) pour fournir ledit signal de rétroaction (fb) et un combineur (110), de préférence un additionneur (110), qui combine ledit signal d'amplitude (A, u) et ledit signal de rétroaction (fb) pour obtenir un signal d'erreur (e).

8. Modulateur d'enveloppe (100, 100a) selon au moins une des revendications précédentes, ledit modulateur d'enveloppe (100) comprenant des moyens de génération d'impulsions (140) qui sont configurés pour générer une ou plusieurs impulsions de sortie (p1, p2, p3).

9. Émetteur polaire (1000) comprenant un modulateur d'enveloppe (100, 100a, 100b, 100c) selon une des revendications précédentes, ledit émetteur polaire (1000) comprenant en outre des moyens (1010) pour obtenir un signal d'amplitude (A, u) et un signal de phase (ph) en fonction d'un signal d'entrée (s_in), des moyens (1020) pour moduler en phase un signal porteur (f_c) en fonction dudit signal de phase (ph) afin d'obtenir un signal porteur modulé en phase (f_c_mod, fcm'), et ledit émetteur polaire (1000) étant configuré pour fournir ledit signal d'amplitude (A, u) et ledit signal porteur modulé en phase (f_c_mod, fcm') audit modulateur d'enveloppe (100, 100a, 100b, 100c).

10. Procédé de fonctionnement d'un modulateur d'enveloppe (100, 100a, 100b, 100c), en particulier pour un émetteur polaire (1000), dans lequel ledit modulateur d'enveloppe (100) est configuré pour recevoir un signal d'amplitude (A, u) et un signal porteur modulé en phase (f_c_mod, fcm') et dans lequel ledit modulateur d'enveloppe délivre en sortie pendant au moins un cycle d'horloge (T_c) dudit signal porteur modulé en phase (f_c_mod, fcm') une impulsion de sortie (p1, p2, p3), dans lequel une largeur d'impulsion de ladite impulsion de sortie (p1, p2, p3) est déterminée en fonction dudit signal d'amplitude (A) et d'un signal de rétroaction (fb) dérivé dudit signal d'amplitude (A), dans lequel ledit modulateur d'enveloppe (100) compare ladite largeur d'impulsion déterminée (pw2) de ladite impulsion de sortie (p2) à une valeur de seuil prédéterminée et dans lequel ledit modulateur d'enveloppe (100) ne délivre pas en sortie ladite impulsion de sortie (p2) si ladite largeur d'impulsion déterminée (pw2) est inférieure à ladite valeur de seuil prédéterminée.

**11.** Procédé selon la revendication 10, dans lequel ledit modulateur d'enveloppe (100) génère des impulsions de sortie (p1, p2, p3) avec au moins deux largeurs d'impulsion différentes (pw2).

**12.** Procédé selon au moins une des revendications 10 et 11, dans lequel ladite largeur d'impulsion est, de préférence au moins approximativement, déterminée en fonction de l'équation suivante : PW = c1 * arc-sinus (y' (t)), dans laquelle PW représente ladite largeur d'impulsion, dans laquelle c1 représente une première constante, dans laquelle arc-sinus() représente la fonction inverse du sinus et dans laquelle y' (t) représente un signal dérivé d'une différence (e) entre ledit signal d'amplitude (A) et ledit signal de rétroaction (fb).

**13.** Procédé selon au moins une des revendications 10 à 12, dans lequel ledit modulateur d'enveloppe (100) génère des impulsions de sortie (p1, p2, p3) avec au moins deux niveaux d'amplitude différents.

## Fig. 1

## Fig. 2a

## Fig. 2b

## Fig. 2c

## Fig. 3a

## Fig. 3b

## Fig. 4a

100a

## Fig. 4b

100b

## Fig. 4c

100c

## Fig. 5a

```
┌─────────────────────┐
│                     │ ⌐ 200
└─────────────────────┘
          │
          ▼
┌─────────────────────┐
│                     │ ⌐ 210
└─────────────────────┘
          │
          ▼
┌─────────────────────┐
│                     │ ⌐ 220
└─────────────────────┘
```

## Fig. 5b

```
┌─────────────────────┐
│                     │ ⌐ 250
└─────────────────────┘
          │
          ▼
┌─────────────────────┐
│                     │ ⌐ 252
└─────────────────────┘
          │
          ▼
┌─────────────────────┐
│                     │ ⌐ 254
└─────────────────────┘
          │
          ▼
┌─────────────────────┐
│                     │ ⌐ 256
└─────────────────────┘
          │
          ▼
┌─────────────────────┐
│                     │ ⌐ 258
└─────────────────────┘
          │
          ▼
┌─────────────────────┐
│                     │ ⌐ 260
└─────────────────────┘
          │
          ▼
```

EP 2 733 846 B1

## Fig. 6

## Fig. 7

## Fig. 8

**REFERENCES CITED IN THE DESCRIPTION**

**Patent documents cited in the description**

- WO 2009072071 A1

- EP 1271870 A2